# EUROPÄISCHE PATENTSCHRIFT

(11) **EP 3 787 044 B1**
(45) Veröffentlichungstag und Bekanntmachung des Hinweises auf die Patenterteilung: **04.08.2021**
(21) Anmeldenummer: 20000294.7
(22) Anmeldetag: 17.08.2020
(51) Int. Cl.: H01L 31/0687, H01L 31/048, H01L 31/18, H01L 21/78, H01L 21/301, H01L 21/268

(54) **VEREINZELUNGSVERFAHREN ZUR VEREINZELUNG EINER MEHRERE SOLARZELLENSTAPEL UMFASSENDEN HALBLEITERSCHEIBE**
SEPARATION METHOD FOR SEPARATING A SEMICONDUCTOR WAFER COMPRISING A PLURALITY OF SOLAR CELL STACKS
PROCÉDÉ DE SÉPARATION PERMETTANT DE SÉPARER UNE PLAQUE SEMI-CONDUCTRICE COMPRENANT PLUSIEURS EMPILEMENTS DE CELLULES SOLAIRES

(30) Priorität: 29.08.2019 DE 102019006095
(43) Veröffentlichungstag der Anmeldung: 03.03.2021
(73) Patentinhaber: AZUR SPACE Solar Power GmbH, 74072 Heilbronn (DE)
(72) Erfinder: Sommer, Steffen, 71732 Tamm (DE); Köstler, Wolfgang, 74074 Heilbronn (DE); Frey, Alexander, 74081 Heilbronn (DE)
(74) Vertreter: Koch Müller Patentanwaltsgesellschaft mbH

(56) Entgegenhaltungen:
- EP-A2- 0 926 743
- EP-A2- 2 426 734
- US-A1- 2011 247 672
- US-A1- 2017 345 955
- US-A1- 2018 097 133
- US-B1- 6 300 558
- DONGSHI ZHANG ET AL: "Debris-free rear-side picosecond laser ablation of thin germanium wafers in water with ethanol", APPLIED SURFACE SCIENCE, Bd. 367, 12. Januar 2016 (2016-01-12), Seiten 222-230, XP055763709, AMSTERDAM, NL ISSN: 0169-4332, DOI: 10.1016/j.apsusc.2016.01.071

## Beschreibung

Die Erfindung betrifft ein Vereinzelungsverfahren zur Vereinzelung einer mehrere Solarzellenstapel umfassenden Halbleiterscheibe.

Halbleiterscheiben (Wafer) werden typischerweise mittels eines Trennschleifprozesses vereinzelt, also mechanisch getrennt. Ebenfalls bekannt ist das Vereinzeln mittels Laser-Ablation entlang von Trennfugen.

Alternativ werden in einem Ritzprozess d.h. in einem sogenannten Scribing Prozess mechanisch oder mittels Laser-Ablation kleine Gräben als Sollbruchstellen entlang von Trennlinien in der Oberseite oder der Unterseite erzeugt und die Halbleiterscheibe anschließend durch Brechen entlang der Sollbruchstellen geteilt.

Ebenso ist es möglich mit einem sogenannten Stealth-Dicing Prozess, auch als verdeckte Vereinzelung bezeichnet, mittels eines In einer bestimmten Tiefe in der Halbleiterscheibe das Material zu modifizieren, wodurch ebenfalls Sollbruchstellen entstehen, entlang derer durch Brechen vereinzeln lässt.

Die Vereinzelungsverfahren sind dabei jeweils an das zu teilende Material, also ein Halbleitermaterial angepasst.

Aus der US 2017/345955 A1, und der US 2018/097133 A1, und der EP 0 926 743 A2, und der EP 2 426 734 A2, und aus DONGSHI ZHANG ET AL: "Debrisfree rear-side picosecond laser ablation of thin germanium wafers in water with ethanol", APPLIED SURFACE SCIENCE, Bd. 367, 12. Januar 2016, Seiten 222-230, US 2011/247672 A1, US 6 300 558 B1 sind Verfahren zum Vereinzein von Halbleiterscheiben bekannt.

Vor diesem Hintergrund besteht die Aufgabe der Erfindung darin, eine Vorrichtung anzugeben, die den Stand der Technik weiterbildet.

Die Aufgabe wird durch ein Vereinzelungsverfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Vereinzelungsverfahren zur Vereinzelung einer mehrere Solarzellenstapel umfassenden Halbleiterscheibe entlang mindestens einer Trennlinie bereitgestellt, mindestens umfassend die Schritte:
- Bereitstellen der Halbleiterscheibe mit einer Oberseite, einer Unterseite, einer mit der Oberseite stoffschlüssig verbundene Haftmittelschicht und eine stoffschlüssig mit der Haftmittelschicht verbundene Deckglasschicht, wobei die Halbleiterscheibe mehrere Solarzellenstapel jeweils aufweisend eine die Unterseite der Halbleiterscheibe ausbildende Germanium-Substratschicht, eine Germanium-Teilzelle und mindestens zwei III-V-Teilzellen umfasst,
- Erzeugen eines von einer Unterseite der Halbleiterscheibe durch die Halbleiterscheibe und die Haftmittelschicht hindurch mindestens bis zu einer an die Haftmittelschicht angrenzenden Unterseite der Deckglasschicht reichenden Trenngrabens entlang der Trennlinie mittels Laser-Ablation und
- Teilen der Deckglasschicht entlang des Trenngrabens.

Es versteht sich, dass die einzelnen Teilzellen der Solarzellenstapel jeweils einen pn-Übergang aufweisen und die auf das Substrat folgenden Schichten epitaktisch aufeinander erzeugt und/oder mittels Wafer-Bond miteinander verbunden sind.

Außerdem versteht es sich, dass eine Ge-Teilzelle Germanium aufweist oder aus Germanium besteht, wobei auch eine aus Germanium bestehende Schicht gegebenenfalls zusätzlich zu dem Germanium noch weitere Stoffe, insbesondere Dotierstoffe, aber auch Verunreinigungen enthält.

Entsprechendes gilt auch für die III-V-Teilzellen, welche ein oder mehrere Materialien der III. sowie der V. Hauptgruppe aufweisen oder aus solchen Materialien bestehen.

Ein mechanisches Trennen des Verbunds aus Halbleiterscheibe, Haftmittel und Deckglasschicht ist aufgrund der Härte des Glases und der zu erwartenden Ablagerungen des Haftmittels auf einer Trennscheibe nicht möglich.

Dadurch dass der Trenngraben von der Unterseite der Halbleiterscheibe nur bis zu der Unterseite der Deckglasschicht oder einen an die Unterseite direkt angrenzenden Bereich der Deckglasschicht erzeugt wird, ist das Erzeugen des Trenngrabens trotz der sehr unterschiedlichen optischen und thermischen Eigenschaften möglich, insbesondere ohne die Haftmittelschicht unnötig zu beschädigen.

Es versteht sich, dass der Trenngraben an der Unterseite der Halbleiterscheibe eine ausreichende Breite aufweisen muss, um den Laserstrahl für die Laser-Ablation bis zu der Deckglasschicht bis in ausreichende Tiefen fokussieren zu können. Andererseits fungiert der Trenngraben in der Halbleiterscheibe als Blende und verringert eine Rückstreuung von der Deckglasschicht in aktive Schichten der Halbleiterscheibe.

Das Vereinzelungsverfahren ermöglicht es, den Verbund aus Halbleiterscheibe mit Haftmittel und Deckglas zu vereinzeln. Das Deckglas wird somit bereits auf Wafer-level aufgebracht und muss nur ein einziges Mal und nur verhältnismäßig grob justiert werden.

Darüber hinaus stellt das Vereinzelungsverfahren sicher, dass das Deckglas mit den Seitenflächen der Halbleiterscheibe mindestens bündig abschließt oder sogar einen Überstand aufweist. Hierdurch ist die Oberseite der Halbleiterscheibe zuverlässig vor Umwelteinflüssen geschützt.

Gemäß einer ersten Ausführungsform wird der Trenngraben bis in einen an die Haftmittelschicht angrenzenden Bereich der Deckglasschicht erzeugt wird. Die Laser-Ablation in einem unteren Bereich der Deckglasschicht stellt quasi einen Ritzprozess, auch Scribing genannt, dar. Durch das Anritzen der Deckglasschicht wird beispielsweise ein Brechen der Deckglasschicht entlang der Trenngräben vereinfacht.

In einer anderen Ausführungsform erfolgt das Teilen der Deckglasschicht durch Brechen oder durch Sägen.

Gemäß einer weiteren Ausführungsform wird für die Laser-Ablation ein Laser entlang mindestens einer entlang oder parallel zu der Trennlinie verlaufenden Spur auf der Unterseite der Halbleiterscheibe bewegt und erfolgen mittels eines fokussierten Laserstrahls Energieeinträge entlang der Spur.

In einer Weiterbildung erfolgt der Energieeintrag entlang von mindestens 2 und höchstens 30 Spuren.

Gemäß einer anderen Weiterbildung erfolgt in einem Ablations-Durchgang der Energieeintrag entlang von n Spuren mit 1 ≤ n ≤ 30 und der Ablations-Durchgang wird mindestens einmal wiederholt, wobei bei jeder Wiederholung die Anzahl n der Spuren gleich bleibt oder reduziert wird und wobei die Anzahl n bei mindestens einer Wiederholung reduziert wird.

In einer weiteren Ausführungsform wird der Ablations-Durchgang mindestens einmal und höchstens 40 Mal wiederholt.

Gemäß einer anderen Ausführungsform erfolgt in einem Ablations-Durchgang der Energieeintrag mit einer ersten Leistungsdichte und mit einer ersten Fokusebene und wird mindestens einmal wiederholt, wobei bei mindestens einer Wiederholung die Leistungsdichte und/oder die Fokusebene verändert wird.

Gemäß einer weiteren Weiterbildung wird vor dem Erzeugen des Grabens die Oberseite der Deckglasschicht stoffschlüssig mit einer Folie verbunden.

In einer anderen Weiterbildung umfasst die Haftmittelschicht Silikon und weist eine Dicke von mindestens 5µm auf.

Gemäß einer weiteren Ausführungsform weist die Deckglasschicht eine Schichtdicke von mindestens 50 µm auf.

In einer anderen Ausführungsform erfolgt der Energieeintrag mittels eines gepulsten Lasers, wobei eine Pulsdauer zwischen 10 fs und 100 ns beträgt und/oder eine Wellenlänge zwischen 315 nm und 1070 nm oder zwischen 1,5 µm und 10,6 µm beträgt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigt:
- Figur 1: einen schematischen Ablauf gemäß einer ersten Ausführungsform eines erfindungsgemäßen Vereinzelungsverfahrens einer Halbleiterscheibe,
- Figur 2: eine Ansicht einer zweite erfindungsgemäße Ausführungsform des Vereinzelungsverfahrens,
- Figur 3: eine Ansicht einer weiteren erfindungsgemäßen Ausführungsform des Vereinzelungsverfahrens,
- Figur 4: eine weitere Ansicht des Vereinzelungsverfahrens.

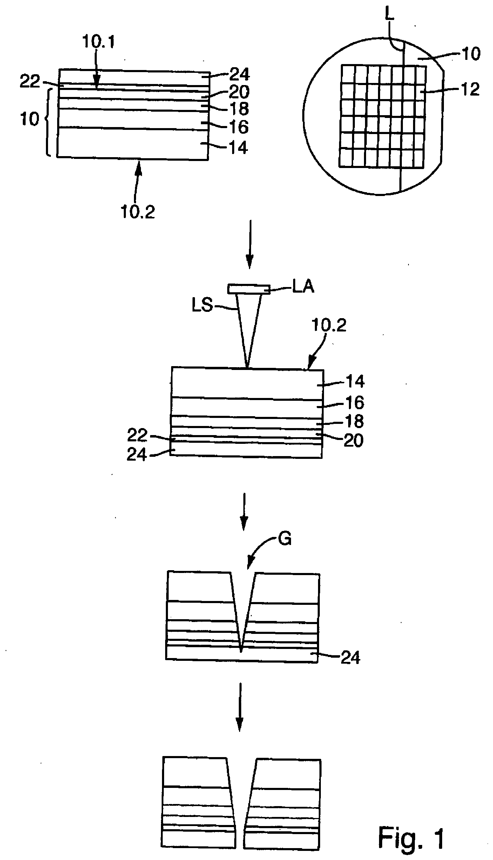

Die Abbildung der Figur 1 zeigt schematisch einen Ablauf eines Vereinzelungsverfahrens zur Vereinzelung einer mehrere Solarzellenstapel umfassenden Halbleiterscheibe gemäß einer ersten erfindungsgemäßen Ausführungsform.

Es wird eine mehrere Solarzellenstapel 12 umfassende Halbleiterscheibe 10 mit einer Oberseite 10.1 und einer Unterseite 10.2 bereitgestellt. Die Halbleiterscheibe 10 umfasst eine Schichtfolge aus einem die Unterseite 10.1 ausbildenden Germanium-Substrat 14, einer Germanium-Teilzelle 16, einer ersten III-V-Teilzelle 18 und einer die Oberseite 10.1 ausbildenden zweiten III-V-Teilzelle 20. Auf der Oberseite 10.1 ist eine Haftmittelschicht 22 und auf der Haftmittelschicht 22 eine Deckglasschicht 24 angeordnet.

Die Solarzellenstapel 12 der Halbleiterscheibe 10 werden entlang von Trennlinien L vereinzelt. Hierfür wird mittels Laser-Ablation mit einem entlang der Trennlinien L bewegten Lasers und eines auf die Unterseite 10.2 der Halbleiterscheibe auftreffenden Laserstrahls LS ein von der Unterseite 10.2 durch die Substratschicht 14 und die Teilzellen 16, 18, 20 der Halbleiterscheibe 10 sowie durch die Haftmittelschicht 22 bis in die Deckglasschicht 24 hinein reichender Graben G erzeugt. Der Graben G endet in einem an die Haftmittelschicht 22 angrenzenden Bereich der Deckglasschicht 24, wobei der Bereich maximal ein Drittel der Gesamtdicke der Deckglasschicht 24 einnimmt.

Anschließend wird die Deckglasschicht 24 entlang der Trennlinien L durch Brechen oder durch Sägen geteilt, wodurch die Solarzellenstapel voneinander getrennt werden.

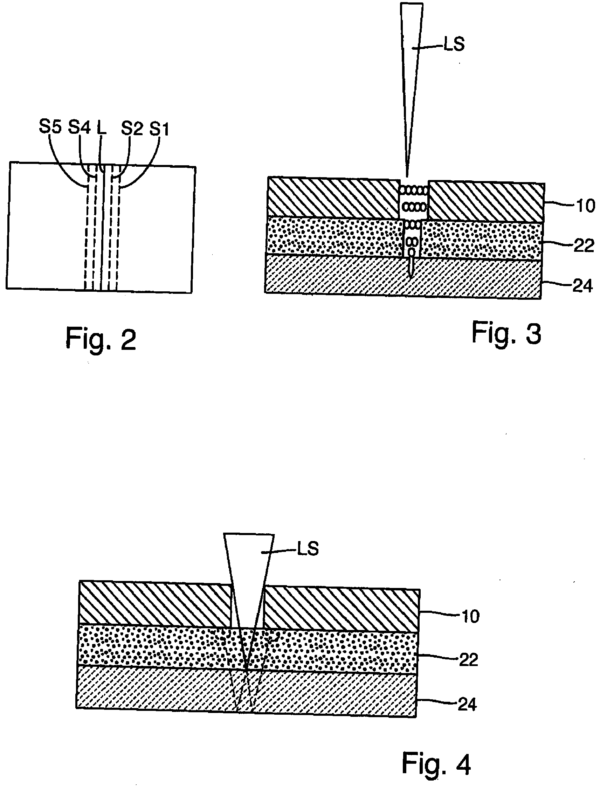

In der Abbildung der Figur 2 ist eine weitere Ausführungsform dargestellt. Im Folgenden werden nur die Unterschiede zu der Abbildung der Figur 1 erläutert.

Um den Graben G entlang einer Trennlinie L zu erzeugen, erfolgt die Laser-Ablation entlang der Trennlinie L sowie entlang von vier weiteren parallel zu der Trennlinie L verlaufenden Spuren S1, S2, S4, S5 bewegt.

In der Abbildung der Figur 3 ist eine weitere Ausführungsform dargestellt. Im Folgenden werden nur die Unterschiede zu der Abbildung der Figur 2 erläutert.

Die Laser-Ablation erfolgt in fünf Durchgängen, wobei die Laser-Ablation in einem ersten Durchgang entlang der Trennlinie und weiterer vier Spuren erfolgt. In jedem weiteren Durchgang erfolgt die Laser-Ablation mit einer tiefer liegenden Fokusebene und entlang einer um eins verringerten Anzahl von Spuren.

In der Abbildung der Figur 3 ist ein Lichtverlauf durch die Halbleiterscheibe 10, die Haftmittelschicht 22 und der Deckglasschicht 24 dargestellt.

Von der Austrittfläche der Deckglasschicht 24 gebeugtes Licht kann, wie in dem dargestellten Fall, auf die Oberseite 10.1 der Halbleiterscheibe 10 treffen und die Oberseite 10.1 der Halbleiterscheibe 10 schädigen.

Mit einer geeigneten Wahl der Energiedichte bzw. der Intensität und des Fokusverlaufs wird eine Schädigung unterdrückt oder zumindest reduziert.

Insbesondere schwächt sich die Intensität beispielsweise stark ab, wenn der Laserstrahl LS einen großen Öffnungswinkel aufweist, d.h. wenn sich der Laserstrahl nach der Fokusebene also schnell aufweitet.

Es sei angemerkt, dass sich bei der Bearbeitung mit einer größeren Rayleighlänge in Verbindung mit einer geeigneten Breite des Grabens G das Auftreffen von reflektiertem Licht auf der Oberseite 10.1 der Halbleiterscheibe 10 zuverlässig unterdrücken lässt.

## Patentansprüche

1. Vereinzelungsverfahren zur Vereinzelung einer mehrere Solarzellenstapel (12) umfassenden Halbleiterscheibe (10) entlang mindestens einer Trennlinie (L) mindestens umfassend die Schritte:
- Bereitstellen der Halbleiterscheibe (10) mit einer Oberseite (10.1), einer Unterseite (10.2), einer mit der Oberseite (10.1) stoffschlüssig verbundene Haftmittelschicht (22) und eine stoffschlüssig mit der Haftmittelschicht (22) verbundene Deckglasschicht (24),
- wobei die Halbleiterscheibe (10) mehrere Solarzellenstapel (12) jeweils aufweisend eine die Unterseite (10.1) der Halbleiterscheibe (10) ausbildende Germanium-Substratschicht (14), eine Germanium-Teilzelle (16) und mindestens zwei III-V-Teilzellen (18, 20) umfasst,
- Erzeugen eines von einer Unterseite (10.2) der Halbleiterscheibe (10) durch die Halbleiterscheibe (10) und die Haftmittelschicht (22) hindurch mindestens bis zu einer an die Haftmittelschicht (22) angrenzenden Unterseite der Deckglasschicht (24) reichenden Trenngrabens (G) entlang der Trennlinie (L) mittels Laser-Ablation und
- Teilen der Deckglasschicht (24) entlang des Trenngrabens.

2. Verfahren nach Anspruch 1, **dadurch gekennzeichnet, dass** der Trenngraben bis in einen an die Haftmittelschicht (22) angrenzenden Bereich der Deckglasschicht (24) erzeugt wird.

3. Verfahren nach Anspruch 1 oder 2, **dadurch gekennzeichnet, dass** das Teilen der Deckglasschicht durch Brechen oder durch Sägen erfolgt.

4. Verfahren nach einem der vorstehenden Ansprüche, **dadurch gekennzeichnet, dass** für die Laser-Ablation ein Laser (LA) entlang mindestens einer entlang oder parallel zu der Trennlinie (L) verlaufenden Spur (S1, S2, S4, S5) auf der Unterseite (10.2) der Halbleiterscheibe (10) bewegt wird und mittels eines fokussierten Laserstrahls (LS) Energieeinträge entlang der Spur erfolgen.

5. Verfahren nach einem der vorstehenden Ansprüche, **dadurch gekennzeichnet, dass** der Energieeintrag entlang von mindestens 2 und höchstens 30 Spuren (S1, S2, S4, S5) erfolgt.

6. Verfahren nach einem der vorstehenden Ansprüche, **dadurch gekennzeichnet, dass** in einem Ablations-Durchgang der Energieeintrag entlang von n Spuren (S1, S2, S4, S5) mit 1 ≤ n ≤ 30 erfolgt und der Ablations-Durchgang mindestens einmal wiederholt wird, wobei bei jeder Wiederholung die Anzahl n der Spuren gleich bleibt oder reduziert wird und wobei die Anzahl n bei mindestens einer Wiederholung reduziert wird.

7. Verfahren nach Anspruch 6, **dadurch gekennzeichnet, dass** der Ablations-Durchgang mindestens einmal und höchstens 40 Mal wiederholt wird.

8. Verfahren nach einem der vorstehenden Ansprüche, **dadurch gekennzeichnet, dass** in einem Ablations-Durchgang der Energieeintrag mit einer ersten Leistungsdichte und mit einer ersten Fokusebene erfolgt und der Ablations-Durchgang mindestens einmal wiederholt wird, wobei bei mindestens einer Wiederholung die Leistungsdichte und/oder die Fokusebene verändert wird.

9. Verfahren nach einem der vorstehenden Ansprüche, **dadurch gekennzeichnet, dass** vor dem Erzeugen des Grabens die Oberseite der Deckglasschicht stoffschlüssig mit einer Folie verbunden wird.

10. Verfahren nach einem der vorstehenden Ansprüche, **dadurch gekennzeichnet, dass** die Haftmittelschicht (22) Silikon umfasst und eine Dicke von mindestens 5 µm aufweist.

11. Verfahren nach einem der vorstehenden Ansprüche, **dadurch gekennzeichnet, dass** die Deckglasschicht (24) eine Schichtdicke von mindestens 50 µm aufweist.

12. Verfahren nach einem der vorstehenden Ansprüche, **dadurch gekennzeichnet, dass** der Energieeintrag mittels eines gepulsten Lasers (LA) erfolgt, wobei eine Pulsdauer zwischen 10 fs und 100 ns beträgt und/oder eine Wellenlänge zwischen 315 nm und 1070 nm oder zwischen 1,5 µm und 10,6 µm beträgt.

## Claims

1. Separation method for separating a semiconductor wafer (10), which comprises a plurality of solar cell stacks (12), along at least one partition line (L), comprising at least the steps:
- providing the semiconductor wafer (10) with an upper side (10.1), a lower side (10.2), an adhesive layer (22) connected by material couple with the upper side (10.1) and a cover glass layer (24) connected by material couple with the adhesive layer (22),
- wherein the semiconductor wafer (10) comprises a plurality of solar cell stacks (12) each having a germanium substrate layer (14) forming the lower side (10.1) of the semiconductor wafer (10), a germanium part cell (16) and at least two III-V part cells (18, 20),
- producing a partition trench (G), which reaches from a lower side (10.2) of the semiconductor wafer (10) through the semiconductor wafer (10) and the adhesive layer (22) at least to a lower side - which adjoins the adhesive layer (22) - of a cover glass layer (24), along the partition line (L) by means of laser ablation and
- dividing the cover glass layer (24) along the partition trench.

2. Method according to claim 1, **characterised in that** the partition trench is produced as far as into a region of the cover glass layer (24) adjoining the adhesive layer (22).

3. Method according to claim 1 or 2, **characterised in that** the dividing of the cover glass layer is carried out by breaking or by sawing.

4. Method according to any one of the preceding claims, **characterised in that** for the laser ablation a laser (LA) is moved along at least one track (S1, S2, S4, S5), which extends along or parallel to the partition line (L), on the lower side (10.2) of the semiconductor wafer (10) and input of energy along a track is carried out by means of a focused laser beam (LS).

5. Method according to any one of the preceding claims, **characterised in that** the input of energy is carried out along at least two and at most thirty tracks (S1, S2, S4, S5).

6. Method according to any one of the preceding claims, **characterised in that** in an ablation pass the input of energy is carried out along n tracks (S1, S2, S4, S5), wherein 1 ≤ n ≤ 30, and the ablation pass is repeated at least once, wherein for each repetition the number n of tracks remains the same or is reduced and wherein the number n is reduced for at least one repetition.

7. Method according to claim 6, **characterised in that** the ablation pass is repeated at least once and at most forty times.

8. Method according to any one of the preceding claims, **characterised in that** in an ablation pass the intake of energy is carried out with a first power density and with a first focal plane and the ablation pass is repeated at least once, wherein the power density and/or the focal plane is or are changed for at least one repetition.

9. Method according to any one of the preceding claims, **characterised in that** prior to producing the trench the upper side of the cover glass layer is connected by material couple with a foil.

10. Method according to any one of the preceding claims, characterised int hat the adhesive layer (22) comprises silicone and has a thickness of at least 5 µm.

11. Method according to any one of the preceding claims, **characterised in that** the cover glass layer (24) has a layer thickness of at least 50 µm.

12. Method according to any one of the preceding claims, **characterised in that** the intake of energy is carried out by means of a pulsed laser (LA), wherein a pulse duration is between 10 fs and 10 ns and/or a wavelength is between 315 nm and 1070 nm or between 1.5 µm and 10.6 µm.

## Revendications

1. Procédé de découpe pour découper une plaquette semi-conductrice (10) comprenant plusieurs piles de cellules solaires (12) le long d'au moins une ligne de séparation (L) comprenant au moins les étapes suivantes :
- préparation de la plaquette semi-conductrice (10) avec une face supérieure (10.1) et une face inférieure (10.2), une couche de matière adhésive (22) liée par combinaison de matière avec la face supérieure (10.1) et une couche de verre de protection (24) liée par combinaison de matière avec la couche de matière adhésive (22),
- la plaquette semi-conductrice (10) comprenant plusieurs piles de cellules solaires (12) présentant chacune une couche de substrat en germanium (14) constituant la face inférieure (10.1) de la plaquette semi-conductrice (10), une sous-cellule en germanium (16) et au moins deux sous-cellules III-V (18, 20),
- réalisation d'une tranchée de séparation (G) allant de la face inférieure (10.2) de la plaquette semi-conductrice (10), à travers la plaquette semi-conductrice (10) et la couche de matière adhésive (22), au moins jusqu'à une face inférieure de la couche de verre de protection (24) adjacente à la couche de matière adhésive (22) le long de la ligne de séparation (L) par ablation laser et
- séparation de la couche de verre de protection (24) le long de la tranchée de séparation.

2. Procédé selon la revendication 1, **caractérisé en ce que** la tranchée de séparation (G) est réalisée jusque dans une région de la couche de verre de protection (24) adjacente à la couche de matière adhésive.

3. Procédé selon la revendication 1 ou 2, **caractérisé en ce que** la séparation de la couche de verre de protection (24) est effectuée par fracture ou par sciage.

4. Procédé selon une des revendications précédentes, **caractérisé en ce que**, pour l'ablation laser, un laser (LA) est déplacé le long d'au moins une piste (S1, S2, S4, S5) courant le long ou parallèle à la ligne de séparation (L) sur la face inférieure (10.2) de la plaquette semi-conductrice (10) et des apports d'énergie ont lieu le long de la piste au moyen d'un faisceau laser (LS) focalisé.

5. Procédé selon une des revendications précédentes, **caractérisé en ce que** l'apport d'énergie a lieu le long d'au moins 2 et d'au plus 30 pistes (S1, S2, S4, S5).

6. Procédé selon une des revendications précédentes, **caractérisé en ce que**, dans un passage d'ablation, l'apport d'énergie a lieu le long de n pistes (S1, S2, S4, S5), n étant ≥ 1 et ≤ 30, et le passage d'ablation est répété au moins une fois, le nombre n de pistes restant égal ou étant réduit à chaque répétition et le nombre n étant réduit lors d'au moins une répétition.

7. Procédé selon la revendication 6, **caractérisé en ce que** le passage d'ablation est répété au moins une fois et au plus 40 fois.

8. Procédé selon une des revendications précédentes, **caractérisé en ce que**, dans un passage d'ablation, l'apport d'énergie a lieu avec une première densité de puissance et avec un premier plan focal et le passage d'ablation est répété au moins une fois, la densité de puissance et/ou le plan focal étant modifiés lors d'au moins une répétition.

9. Procédé selon une des revendications précédentes, **caractérisé en ce qu'**avant la réalisation de la tranchée, la face supérieure de la couche de verre de protection est liée par combinaison de matière avec un film.

10. Procédé selon une des revendications précédentes, **caractérisé en ce que** la couche de matière adhésive (22) comprend de la silicone et présente une épaisseur d'au moins 5 µm.

11. Procédé selon une des revendications précédentes, **caractérisé en ce que** la couche de verre de protection (24) présente une épaisseur de couche d'au moins 50 µm.

12. Procédé selon une des revendications précédentes, **caractérisé en ce que** l'apport d'énergie a lieu au moyen d'un laser (LA) à impulsions, une durée d'impulsion étant de 10 fs à 100 ns et/ou une longueur d'onde étant de 315 nm à 1070 nm ou de 1,5 µm à 10,6 µm.
